# EUROPÄISCHE PATENTSCHRIFT

(11) **EP 2 804 715 B1**
(45) Veröffentlichungstag und Bekanntmachung des Hinweises auf die Patenterteilung: **09.03.2016**
(21) Anmeldenummer: 12816664.2
(22) Anmeldetag: 21.12.2012
(51) Int. Cl.: B23K 26/06, B23K 26/03

(54) **VORRICHTUNG ZUM LASERBEARBEITEN EINES WERKSTÜCKES UNTER VERWENDUNG ZWEIER LASERSTRAHLE**
DEVICE FOR THE LASER PROCESSING OF A WORKPIECE, USING TWO LASER BEAMS
DISPOSITIF POUR L'USINAGE AU LASER D'UNE PIÈCE EN UTILISANT DEUX FAISCEAUX LASER

(30) Priorität: 20.01.2012 DE 102012200857; 27.01.2012 DE 102012201194
(43) Veröffentlichungstag der Anmeldung: 26.11.2014
(73) Patentinhaber: Rofin-Baasel Lasertech GmbH & Co. KG, 82319 Starnberg (DE)
(72) Erfinder: GEIGER, Stephan, 85241 Hebertshausen (DE); WAGENHUBER, Klaus, 81541 München (DE); BOPP, Benjamin, 80339 München (DE); DEEG, Fred-Walter, 83727 Schliersee (DE)
(74) Vertreter: Schlögl, Markus
(86) Internationale Anmeldenummer: PCT/EP2012/076556
(87) Internationale Veröffentlichungsnummer: WO 2013/107597

(56) Entgegenhaltungen:
- DE-B3-102008 032 751
- JP-A- 2005 007 476
- US-B1- 6 313 433

## Beschreibung

Die Erfindung bezieht auf eine Vorrichtung zum Laserbearbeiten eines Werkstückes gemäß dem Oberbegriff des Anspruchs 1 (siehe, z.B., US 6 313 433 B) insbesondere zur Bearbeitung eines Siliziumwafers bei der Herstellung von Solarzellen.

Bei der Produktion von Solarzellen aus kristallinem Silizium spielt der Prozess der Rückseitenöffnung eine entscheidende Rolle. Dabei werden mittels Laserablation sich auf der Rückseite des Wafers befindliche Passivierungsschichten lokal geöffnet, d.h. lokal abgetragen. Diese Passivierungsschichten dienen der Sättigung ungebundener Oberflächenzustände, die zur Rekombination von Ladungsträgern und damit zu einer verminderten Effizienz der Solarzelle führen würden. Eine lokale Öffnung dieser Passivierungsschichten ermöglicht in einem späteren Prozessschritt das Aufbringen von elektrischen Kontakten bei im Übrigen passivierter Rückseite. Zur lokalen Entfernung der Passivierungsschicht ist es bekannt, diese mit einem Laser in Form äquidistanter Linien abzutragen. Entscheidend für die Effizienz der Zelle ist es dabei, ein optimales Verhältnis von Kontaktfläche und passivierter Fläche zu finden. Eine Möglichkeit dieses Verhältnis zu steuern ist eine Veränderung des Abstandes der Linien und damit der Anzahl der Linien pro Wafer.

Neben der Optimierung des Wirkungsgrades und der dafür notwendigen Präzision bei der Laserbearbeitung ist die Prozessgeschwindigkeit maßgeblich für die Wirtschaftlichkeit der Produktion. Die wichtigsten Einflussgrößen für eine maximale Prozessgeschwindigkeit bei der Laserablation sind die Pulsenergie und die Pulsfrequenz der Strahlquelle sowie die Geschwindigkeit der verwendeten Ablenk- und Fokussiereinheit.

Im Stand der Technik ist es bekannt, für den Prozess der Rückseitenöffnung einen von einem Grundmodelaser emittierten Laserstrahl über eine Ablenk- und Fokussiereinheit, in der Regel eine aus Galvanometerspiegeln aufgebaute steuerbare Spiegelanordnung mit einer F-Theta-Linse, über den zu prozessierenden Wafer zu führen. Mit einer speziellen CAD-Software können Layouts erstellt werden, die über eine entsprechende Hardware an die Ablenk- und Fokussiereinheit geschickt werden. Diese wird so angesteuert, dass die Spiegelanordnung den Laserstrahl in Form des Layouts über den Wafer führt. Die derzeit technisch realisierbare Prozessgeschwindigkeit ist dabei insbesondere durch die Geschwindigkeit begrenzt, mit der die innerhalb der Ablenk- und Fokussiereinheit angeordneten Umlenkspiegel mit der erforderlichen Präzision relativ zum Wafer geführt werden können.

Der Erfindung liegt nun die Aufgabe zugrunde, eine Vorrichtung zum Laserbearbeiten anzugeben, mit der die Prozessgeschwindigkeit bei der Laserbearbeitung eines Werkstückes, insbesondere beim Abtragen der Passivierungsschichten auf der Rückseite eines Siliziumwafers erhöht ist.

Die genannte Aufgabe wird gemäß der Erfindung gelöst mit einer Vorrichtung zum Laserbearbeiten mit den Merkmalen des Patentanspruches 1. Gemäß diesen Merkmalen enthält die Vorrichtung eine Einrichtung zum Erzeugen zweier sich unter einem Winkel schiefwinklig, d.h. nicht parallel zueinander ausbreitenden Laserstrahlen, sowie eine Ablenk- und Fokussiereinheit zum Führen und Fokussieren der Laserstrahlen über bzw. auf das Werkstück, wobei die Laserstrahlen in zueinander senkrechten Richtungen linear polarisiert sind.

Durch die gleichzeitige Bearbeitung des Werkstückes mit zwei Laserstrahlen wird eine Verdoppelung der Prozessgeschwindigkeit gegenüber herkömmlichen Verfahren erzielt. Da außerdem die Laserstrahlen in zueinander senkrechten Richtungen linear polarisiert sind, können die Laserstrahlen eng nebeneinander und sich teilweise überlagernd oder kreuzend geführt werden, so dass mit ein und derselben Ablenk- und Fokussiereinheit eng nebeneinander liegende Bereiche der Werkstückoberfläche gleichzeitig bearbeitet werden können.

Da die Einrichtung zum Erzeugen der Laserstrahlen gemäß der Erfindung eine der Ablenk- und Fokussiereinheit vorgeschaltete Strahlführungseinrichtung umfasst, die eine verstellbare Spiegelanordnung zum Verändern der Ausbreitungsrichtung zumindest eines der Laser-strahlen enthält, wird der Abstand der auf dem Werkstück fokussierten Laserstrahlen flexibel eingestellt.

Besonders gleichmäßige und reproduzierbare Bearbeitungsergebnisse werden erzielt, wenn die Spiegelanordnung eine Mehrzahl von Umlenkspiegeln umfasst, die derart verstellbar sind, dass sich die Laserstrahlen unabhängig vom Winkel stets im selben Kreuzungspunkt schneiden, der vorzugsweise im Mittelpunkt einer Apertur der Ablenk- und Fokussiereinheit liegt.

Gemäß der Erfindung umfasst die Strahlführungseinrichtung einen der Ablenk- und Fokussiereinheit vorgelagerten teildurchlässigen Endspiegel, der jeweils einen Teil der Laserstrahlen zur Ablenk- und Fokussiereinheit umlenkt und jeweils den anderen Teil transmittiert, wobei die transmittierten Teilstrahlen einem Polarisationsstrahlteiler zugeführt werden, der die transmittierten Teilstrahlen trennt, und wobei zumindest einer der vom Polarisationsstrahlteiler ausgehenden Teilstrahlen einem Strahllagedetektor zugeführt wird. Auf diese Weise können Positionierfehler der verstellbar gelagerten Umlenkspiegel sowie eine thermisch verursachte Drift der feststehenden Umlenkspiegel erkannt und automatisch kompensiert werden, wenn die von dem oder den Strahllagedetektoren aufgenommenen Messsignale an eine Steuereinrichtung weitergeleitet werden, die die verstellbare Spiegelanordnung abhängig von diesen Messsignalen derart steuert, dass sich die ersten Teilstrahlen stets im selben Kreuzungspunkt schneiden.

Weitere vorteilhafte Ausgestaltungen der Erfindung sind in den weiteren Unteransprüchen angegeben.

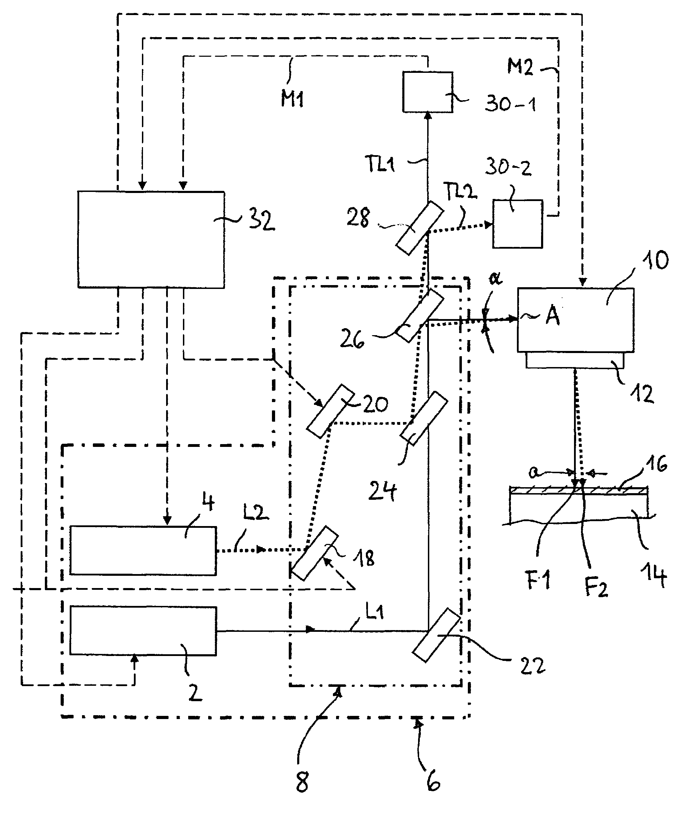

Zur weiteren Erläuterung der Erfindung wird auf das Ausführungsbeispiel der Figur verwiesen, die eine Vorrichtung gemäß der Erfindung in einer Prinzipdarstellung zeigt.

Gemäß dieser Figur umfasst die Vorrichtung eine zwei Laserstrahlquellen 2, 4 enthaltende Einrichtung 6, mit der zwei in zueinander senkrechte Richtungen linear polarisierte Laserstrahlen L1, L2 erzeugt werden. Die Einrichtung 6 enthält eine Strahlführungseinrichtung 8, mit der die beiden aus den Laserstrahlquellen 2, 4 austretenden Laserstrahlen L1, L2 derart ausgerichtet werden, dass sie sich beim Eintritt in eine der Einrichtung 6 nachgeordnete Ablenk- und Fokussiereinheit 10 eng nebeneinander und schiefwinklig unter einem kleinen spitzen Winkel α zueinander ausbreiten. In der Ablenk- und Fokussiereinheit 10 werden die Laserstrahlen L1, L2 mit in der Figur nicht dargestellten verstellbaren Umlenkspiegeln abgelenkt und mit einer F-Theta-Linse 12 in nebeneinanderliegenden Foki F1, F2 in einer Bearbeitungsebene auf ein Werkstück 14 fokussiert. Bei dem Werkstück 14 handelt es sich um einen Siliziumwafer, dessen Rückseite mit einer Passivierungsschicht 16 versehen ist, und der mit seiner Rückseite der Ablenk- und Fokussiereinheit 10 zugewandt ist.

Die Strahlführungseinrichtung 8 umfasst zwei motorisch verstellbare Umlenkspiegel 18, 20, mit denen die Ausbreitungsrichtung des aus der Laserstrahlquelle 4 austretenden Laserstrahls L2 gesteuert werden kann. Der aus der Laserstrahlquelle 2 austretende Laserstrahl L1 wird ausschließlich über feststehende Umlenkspiegel 22, 24 und einen feststehenden Endspiegel 26 geführt, zu dem auch der Laserstrahl L1 gelenkt wird, wobei es sich bei dem Umlenkspiegel 24 um einen Polarisationsstrahlteiler handelt, der den Laserstrahl L1 transmittiert und den Laserstrahl L2 reflektiert, so dass sich beide Laserstrahlen L1, L2 zum Endspiegel 26 hin ausbreiten. Die motorisch verstellbaren Umlenkspiegel 18 und 20 sind dabei derart positioniert, dass sich die Laserstrahlen L1 und L2 im Mittelpunkt A einer Apertur der Ablenk- und Fokussiereinheit 10 kreuzen bzw. überlagern. Mit den Umlenkspiegeln 18, 20 kann der Winkel α und damit der Abstand a der Foki F1, F2 auf dem Werkstück 14 flexibel eingestellt werden.

Da zwei Laserstrahlen L1 und L2 durch die Ablenk- und Fokussiereinheit 10 geführt werden, werden deren Foki F1, F2 durch Bewegung der in der Ablenk- und Fokussiereinheit 10 befindlichen Umlenkspiegel auf dem Werkstück entlang zweier paralleler Linien geführt, entlang derer im Beispiel die Passivierungsschicht 16 abgetragen wird. Für die Bearbeitung des Wafers mit n Linien müssen dementsprechend die Foki F1, F2 nur n/2 mal über den Wafer geführt werden. Dadurch reduziert sich auch die Prozesszeit um die Hälfte.

Der Endspiegel 26 ist teildurchlässig und transmittiert jeweils einen kleinen Teil der Laserstrahlen L1, L2. Die vom Endspiegel 26 transmittierten Teilstrahlen TL1, TL2 werden in einem Polarisationsstrahlteiler voneinander getrennt und jeweils einem Strahllagedetektor 30-1, 30-2 zugeführt. Diese messen jeweils die Strahllage, d.h. sowohl Winkel als auch Position der jeweiligen Teilstrahlen TL1, TL2. Die von den Strahllagedetektoren 30-1, 30-2 erfassten Messsignale M1, M2 werden einer Steuereinrichtung 32 zugeführt, mit der die Umlenkspiegel 18 und 20 und damit die Strahllage des Laserstrahls L2 innerhalb der Strahlführungseinrichtung 8 und damit der Winkel α zwischen den sich zwischen der Strahlführungseinrichtung 8 und der Ablenk- und Fokussiereinheit 10 ausbereitenden Laserstrahlen L1 und L2 gesteuert werden. Die beiden Umlenkspiegel 18, 20 werden dabei so bewegt, dass der Kreuzungspunkt der in die Ablenk- und Fokussiereinheit 10 eingekoppelten Laserstrahlen L1, L2 und somit der Scheitelpunkt der Kippbewegung stets im Mittelpunkt A der Apertur der Ablenk- und Fokussiereinheit 10 liegt. Durch die Variation dieses Winkels α wird der Abstand a der Foki F1, F2 in der Bearbeitungsebene eingestellt. Somit ist es möglich, innerhalb eines physikalisch sinnvollen Rahmens, beliebige Abstände der Ablationslinien auf dem Wafer zu realisieren.

Essentiell für die Effizienz der Solarzellen ist die räumliche Präzision mit der die Wafer bei der Laserablation bearbeitet werden. Thermisch bedingte Drifte der optischen Elemente, mit der die Laserstrahlen geführt werden, können jedoch dazu führen, dass sich der Abstand a der Foki F1, F2 und damit der Linien ändert, was sich negativ auf den Wirkungsgrad der Zelle auswirken könnte. Die aktive Strahlregelung sorgt dafür, dass eine Drift des von der Strahlquelle 2 emittierten und in der Strahlführungseinrichtung geführten Laserstrahls L1 dadurch kompensiert wird, dass der von der Strahlquelle 4 emittierte Laserstrahl L2 nachgeführt wird, so dass die Winkellage der vom Endspiegel 28 reflektierten Laserstrahlen L1, L2 zueinander sowie deren Kreuzungspunkt und damit der Linienabstand a auf dem Siliziumwafer konstant bleiben.

Der Bediener der Anlage kann per Software den gewünschten Abstand der Foki F1, F2 in der Prozessebene vorgeben und die Steuereinrichtung 32 realisiert diesen durch die passende Bewegung der motorisierten Umlenkspiegel 18, 20.
In Kombination mit der Wahl des passenden Layouts kann dann das Werkstück 14, im Beispiel der Siliziumwafer mit äquidistanten Ablationslinien im gewünschten Abstand prozessiert werden.

Im Ausführungsbeispiel sind zwei Laserstrahlquellen 2, 4 vorgesehen. Grundsätzlich können jedoch auch mit einer einzigen Laserstrahlquelle mit entsprechenden Polarisationstrahlteilern zwei senkrecht zueinander linear polarisierte Laserstrahlen erzeugt werden.

## Patentansprüche

1. Vorrichtung zum Laserbearbeiten eines Werkstückes (14), mit einer Einrichtung (6) zum Erzeugen eines ersten und eines zweiten Laserstrahls (L1, L2), die sich unter einem Winkel (α) schiefwinklig zueinander ausbreiten und in zueinander senkrechten Richtungen linear polarisiert sind, einer Ablenk- und Fokussiereinheit (10) zum Führen und Fokussieren der Laserstrahlen (L1, L2) über bzw. auf das Werkstück (14), wobei die Einrichtung (6) zum Erzeugen der Laserstrahlen (L1, L2) eine der Ablenk- und Fokussiereinheit vorgeschaltete Strahlführungseinrichtung (8) umfasst, die eine verstellbare Spiegelanordnung zum Verändern der Ausbreitungsrichtung zumindest eines der Laserstrahlen (L2) enthält,
**gekennzeichnet durch**
einen in der Strahlführungseinrichtung (8) angeordneten und der Ablenk- und Fokussiereinheit (10) vorgelagerten teildurchlässigen Endspiegel (26), der jeweils einen Teil der Laserstrahlen zur Ablenk- und Fokussiereinheit (10) umlenkt und jeweils den anderen Teil transmittiert, wobei die transmittierten Teilstrahlen (TL1, TL2) einem Polarisationsstrahlteiler (28) zugeführt werden, der die transmittierten Teilstrahlen (TL1, TL2) trennt, und wobei zumindest einer der vom Polarisationsstrahlteiler (28) ausgehenden Teilstrahlen (TL1, TL2) einem Strahllagedetektor (30-1, 30-2) zugeführt wird.

2. Vorrichtung nach Anspruch 1, bei der die Spiegelanordnung eine Mehrzahl von Umlenkspiegeln (18, 20) umfasst, die derart verstellbar sind, dass sich die Laserstrahlen (L1, L2) unabhängig vom Winkel (α) stets im selben Kreuzungspunkt schneiden.

3. Vorrichtung nach Anspruch 2, bei der der Kreuzungspunkt im Mittelpunkt (A) einer Apertur der Ablenk- und Fokussiereinheit (10) liegt.

4. Vorrichtung nach einem der Ansprüche 1 bis 3, mit einer Steuereinrichtung (32) zum Steuern der verstellbaren Spiegelanordnung in Abhängigkeit eines von dem oder den Strahllagedetektoren (30-1, 30-2) an die Steuereinrichtung weitergeleiteten Messsignals (M1, M2) derart, dass sich die Laserstrahlen unabhängig vom Winkel (α) stets im selben Kreuzungspunkt schneiden.

5. Vorrichtung nach Anspruch 4, bei der der Kreuzungspunkt im Mittelpunkt (A) einer Apertur der Ablenk- und Fokussiereinheit (10) liegt.

6. Vorrichtung nach einem der vorhergehenden Ansprüche, bei der die Einrichtung (6) zwei Laserstrahlquellen (2, 4) umfasst.

7. Verwendung einer Vorrichtung nach einem der vorhergehenden Ansprüche zum lokalen Abtragen einer Passivierungsschicht (16) auf der Rückseite eines Siliziumwafers bei der Herstellung von Solarzellen.

## Claims

1. Device for the laser processing of a work piece (14), having a device (6) for the generation of a first and a second laser beam (L1, L2) which propagate obliquely relative to each other at an angle (α) and are linearly polarised in directions that are perpendicular to each other, having a deflection and focusing unit (10) for guiding and focusing the laser beams (L1, L2) above or onto the work piece (14), wherein the device (6) for the generation of the laser beams (L1, L2) comprises a beam guiding device (8) upstream of the deflection and focusing unit, said beam guiding device (8) containing an adjustable mirror arrangement for altering the propagation direction of at least one of the laser beams (L2),
**characterised by**
a partially transparent end mirror (26) arranged in the beam guiding device (8) and upstream of the deflection and focusing unit (10), said end mirror diverting a respective part of the laser beams towards the deflection and focusing unit (10) and transmitting the respective other part, wherein the transmitted partial beams (TL1, TL2) are supplied to a polarisation beam splitter (28) which splits the transmitted partial beams (TL1, TL2), and wherein at least one of the partial beams (TL1, TL2) emanating from the polarisation beam splitter (28) is supplied to a beam position detector (30-1, 30-2).

2. Device according to claim 1, wherein the mirror arrangement comprises a plurality of diverting mirrors (18, 20) which are able to be adjusted in such a way that the laser beams (L1, L2) always intersect at the same point of intersection regardless of the angle (α).

3. Device according to claim 2, wherein the point of intersection lies in the centre (A) of an aperture of the deflection and focusing unit (10).

4. Device according to one of claims 1 to 3, having a control device (32) for controlling the adjustable mirror arrangement depending on a measurement signal (M1, M2) transmitted from the beam position detector(s) (30-1, 30-2) to the control device in such a way that the laser beams always intersect at the same point of intersection regardless of the angle (α).

5. Device according to claim 4, wherein the point of intersection lies in the centre (A) of an aperture of the deflection and focusing unit (10).

6. Device according to one of the preceding claims, wherein the device (6) comprises two laser beam sources (2, 4).

7. Use of a device according to one of the preceding claims for the local removal of a passivation layer (16) on the rear side of a silicon wafer during the production of solar cells.

## Revendications

1. Installation d'usinage d'une pièce (14) au laser, comprenant un dispositif (6) de production d'un premier et d'un deuxième faisceaux (L1, L2) laser, qui se propagent en angle oblique l'un par rapport à l'autre d'un angle (α), qui sont polarisés linéairement dans des directions perpendiculaires entre elles, une unité (10) de déviation et de focalisation pour guider et focaliser les faisceaux (L1, L2) laser au-dessus de la pièce (14) ou sur celle-ci, le dispositif (6) de production des faisceaux (L1, L2) laser comprenant un dispositif (8) de guidage de faisceaux, qui est monté en amont de l'unité de déviation et de focalisation et qui comporte un agencement de miroirs réglable pour modifier la direction de propagation d'au moins l'un des faisceaux (L2) laser,
**caractérisée par**
un miroir (26) final semi-transparent, qui est disposé dans le dispositif (8) de guidage de faisceaux, qui est monté en amont de l'unité (10) de déviation et de focalisation, qui dévie respectivement une partie des faisceaux laser vers l'unité (10) de déviation et de focalisation et qui transmet respectivement l'autre partie, les faisceaux (TL1, TL2) partiels transmis étant envoyés à un diviseur (28) de faisceaux de polarisation, qui sépare les faisceaux (TL1, TL2) partiels transmis et dans lequel au moins l'un des faisceaux (TL1, TL2) partiels sortant du diviseur (28) de faisceaux de polarisation est envoyé à un détecteur (30-1, 30-2) de position du faisceau.

2. Installation suivant la revendication 1, dans laquelle l'agencement de miroirs comprend une pluralité de miroirs (18, 20) de déviation, qui sont réglables de manière à ce que les faisceaux (L1, L2) laser se coupent toujours en le même point d'intersection indépendamment de l'angle (α).

3. Installation suivant la revendication 2, dans laquelle le point d'intersection se trouve au centre (A) d'une ouverture de l'unité (10) de déviation et de focalisation.

4. Installation suivant l'une des revendications 1 à 3, comprenant un dispositif (32) de commande de l'agencement réglable de miroirs en fonction d'un signal (M1, M2) de mesure acheminé au dispositif de commande par le ou par les détecteurs (30-1, 30-2) de position du faisceau, de manière à ce que les faisceaux laser se coupent toujours au même point d'intersection indépendamment de l'angle (α).

5. Installation suivant la revendication 4, dans laquelle le point d'intersection est au milieu (A) d'une ouverture de l'unité (10) de déviation et de focalisation.

6. Installation suivant l'une des revendications précédentes, dans laquelle le dispositif (6) comprend deux sources (2, 4) de faisceau laser.

7. Utilisation d'une installation suivant l'une des revendications précédentes pour enlever localement une couche (16) de passivation sur la face arrière d'une tranche de silicium dans la fabrication de cellules solaires.
